# EUROPEAN PATENT APPLICATION

(11) **EP 4 823 246 A1**
(43) Date of publication of application: **14.10.2026**
(21) Application number: 24900362.5
(22) Date of filing: 07.11.2024
(51) Int. Cl.: H05K 1/02, H05K 1/14, H05K 3/36, H05K 9/00

(54) **STACK SUBSTRATE AND METHOD FOR MANUFACTURING STACK SUBSTRATE**

(30) Priority: 04.12.2023 JP 2023204545
(71) Applicant: Mitsubishi Electric Corporation, Tokyo 100-8310 (JP)
(72) Inventor: SAKAMOTO, Tatsuya, Tokyo 100-8310 (JP); ARAI, Hitoshi, Tokyo 100-8310 (JP); GOTO, Hiroshi, Tokyo 100-8310 (JP); NAKAMURA, Keisuke, Tokyo 100-8310 (JP)
(74) Representative: Hoffmann Eitle
(86) International application number: PCT/JP2024/039575
(87) International publication number: WO 2025/121067

(57) **Abstract**

A stack circuit board includes: a first circuit board; a second circuit board; and an electronic component. The first circuit board has a first base member and a first wiring layer made of a conductive material and formed on a first main surface of the first base member. The second circuit board has a second base member and a second wiring layer made of a conductive material and formed on a second main surface of the second base member. The first main surface is provided with a recess. The second main surface has a component arrangement region facing the recess and having the electronic component arranged therein. The electronic component is connected to the second wiring layer in a space defined by the recess and the component arrangement region. One of the first wiring layer and the second wiring layer has a protrusion. The other of the first wiring layer and the second wiring layer is provided with a groove. The protrusion and the groove surround the component arrangement region in a plan view. The groove and the protrusion are fitted, whereby the first base member and the second base member are stacked such that the first main surface and the second main surface face each other.

## Description

### TECHNICAL FIELD

The present disclosure relates to a stack circuit board and a method for manufacturing a stack circuit board.

### BACKGROUND ART

Japanese Patent Laying-Open No. 2017-112015 (PTL 1) describes a stack circuit board. The stack circuit board described in PTL 1 has a first circuit board and a second circuit board. The first circuit board has a first main surface. The second circuit board has a second main surface. The first circuit board and the second circuit board are stacked such that the first main surface and the second main surface face each other. The first main surface is provided with a concave fitting portion. The second main surface is provided with a convex fitting portion. In a state where the first circuit board and the second circuit board are stacked, the concave fitting portion and the convex fitting portion are fitted to each other.

### CITATION LIST

### PATENT LITERATURE

PTL 1: Japanese Patent Laying-Open No. 2017-112015

### SUMMARY OF INVENTION

### TECHNICAL PROBLEM

In the stack circuit board described in PTL 1, the concave fitting portion and the convex fitting portion are not made of metal and the concave fitting portion and the convex fitting portion do not have the electromagnetic shielding function. The present disclosure has been made in view of the above-described problem of the related art. More specifically, the present disclosure provides a stack circuit board that enables electromagnetic shielding of a circuit block.

### SOLUTION TO PROBLEM

A stack circuit board according to the present disclosure includes: a first circuit board; a second circuit board; and an electronic component. The first circuit board has a first base member and a first wiring layer made of a conductive material and formed on a first main surface of the first base member. The second circuit board has a second base member and a second wiring layer made of a conductive material and formed on a second main surface of the second base member. The first main surface is provided with a recess. The second main surface has a component arrangement region facing the recess and having the electronic component arranged therein. The electronic component is connected to the second wiring layer in a space defined by the recess and the component arrangement region. One of the first wiring layer and the second wiring layer has a protrusion. The other of the first wiring layer and the second wiring layer is provided with a groove. The protrusion and the groove surround the component arrangement region in a plan view. The groove and the protrusion are fitted, whereby the first base member and the second base member are stacked such that the first main surface and the second main surface face each other.

### ADVANTAGEOUS EFFECTS OF INVENTION

The stack circuit board according to the present disclosure enables electromagnetic shielding of a circuit block.

### BRIEF DESCRIPTION OF DRAWINGS

Fig. 1 is a cross-sectional view of a stack circuit board 100.
Fig. 2 is a diagram of a process for manufacturing stack circuit board 100.
Fig. 3 is a cross-sectional view illustrating a preparing step S11.
Fig. 4 is a cross-sectional view illustrating a base member processing step S12.
Fig. 5 is a cross-sectional view illustrating a first plating step S13.
Fig. 6 is a cross-sectional view illustrating a wiring layer patterning step S14.
Fig. 7 is a cross-sectional view illustrating a second plating step S15.
Fig. 8 is a cross-sectional view illustrating a preparing step S21.
Fig. 9 is a cross-sectional view illustrating a base member processing step S22.
Fig. 10 is a cross-sectional view illustrating a first plating step S23.
Fig. 11 is a cross-sectional view illustrating a wiring layer patterning step S24.
Fig. 12 is a cross-sectional view illustrating a second plating step S25.
Fig. 13 is a cross-sectional view illustrating an electronic component mounting step S4.
Fig. 14 is a perspective view of a circuit board 20 in stack circuit board 100 according to a first modification.
Fig. 15 is a cross-sectional view of stack circuit board 100 according to a second modification.
Fig. 16 is a cross-sectional view of stack circuit board 100 according to a third modification.
Fig. 17 is a cross-sectional view of a stack circuit board 200.

### DESCRIPTION OF EMBODIMENTS

### First Embodiment.

A stack circuit board according to a first embodiment will be described. The stack circuit board according to the first embodiment will be referred to as a stack circuit board 100.

### (Configuration of Stack Circuit Board 100)

A configuration of stack circuit board 100 will be described below.

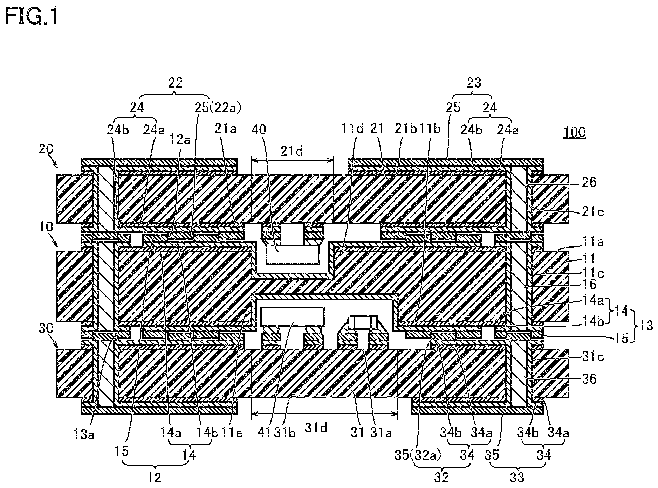

Fig. 1 is a cross-sectional view of stack circuit board 100. As shown in Fig. 1, stack circuit board 100 has a circuit board 10, a circuit board 20, a circuit board 30, an electronic component 40, and an electronic component 41.

Circuit board 10 has a base member 11, a wiring layer 12 and a wiring layer 13. Base member 11 has a main surface 11a and a main surface 11b. Main surface 11a and main surface 11b are end faces in a thickness direction of base member 11. Main surface 11b is opposite to main surface 11a. Base member 11 is provided with a through hole 11c. Through hole 11c passes through base member 11 in the thickness direction. Base member 11 is made of glass cloth and a resin material impregnated into glass cloth.

Main surface 11a is provided with a recess 11d. Main surface 11a is recessed toward the main surface 11b side in recess 11d. Main surface 11b is provided with a recess 11e. Main surface 11b is recessed toward the main surface 11a side in recess 11e.

Wiring layer 12 is arranged on main surface 11a. Wiring layer 13 is arranged on main surface 11b. Each of wiring layer 12 and wiring layer 13 has an underlying layer 14 and a plated layer 15. Underlying layer 14 has a first layer 14a and a second layer 14b. A constituent material for underlying layer 14 and a constituent material for plated layer 15 are, for example, copper, nickel, gold or the like.

First layer 14a constituting a part of wiring layer 12 is arranged on main surface 11a. First layer 14a constituting a part of wiring layer 13 is arranged on main surface 11b. Second layer 14b is arranged on first layer 14a. Second layer 14b is also arranged on an inner wall surface of through hole 11c. Wiring layer 12 and wiring layer 13 are electrically connected to each other by second layer 14b arranged on the inner wall surface of through hole 11c. Second layer 14b is also arranged on a bottom surface and a side surface of recess 11d and on a bottom surface and a side surface of recess 11e. On the bottom surface and the side surface of recess 11d and on the bottom surface and the side surface of recess 11e, underlying layer 14 is configured only of second layer 14b.

Plated layer 15 is arranged on underlying layer 14. However, plated layer 15 is not arranged on underlying layer 14 (second layer 14b) located on the bottom surface and the side surface of recess 11d and on the bottom surface and the side surface of recess 11e. A filling member 16 is filled into through hole 11c. A constituent material for filling member 16 is, for example, a conductive resin formed by compounding copper, a metal powder and a resin, a hole filling resin, or the like.

Circuit board 20 has a base member 21, a wiring layer 22 and a wiring layer 23. Base member 21 has a main surface 21a and a main surface 21b. Main surface 21a and main surface 21b are end faces in a thickness direction of base member 21. Main surface 21b is opposite to main surface 21a. Base member 21 is provided with a through hole 21c. Through hole 21c passes through base member 21 in the thickness direction. Base member 21 is made of glass cloth and a resin material impregnated into glass cloth. Main surface 21a has a component arrangement region 21d.

Wiring layer 22 is arranged on main surface 21a. Wiring layer 23 is arranged on main surface 21b. Each of wiring layer 22 and wiring layer 23 has an underlying layer 24 and a plated layer 25. Underlying layer 24 has a first layer 24a and a second layer 24b. A constituent material for underlying layer 24 and a constituent material for plated layer 25 are, for example, copper, nickel, gold or the like.

First layer 24a constituting a part of wiring layer 22 is arranged on main surface 21a. First layer 24a constituting a part of wiring layer 23 is arranged on main surface 21b. Second layer 24b is arranged on first layer 24a. Second layer 24b is also arranged on an inner wall surface of through hole 21c. Wiring layer 22 and wiring layer 23 are electrically connected to each other by second layer 24b arranged on the inner wall surface of through hole 21c. Plated layer 25 is arranged on underlying layer 24. A filling member 26 is filled into through hole 21c. A constituent material for filling member 26 is, for example, a conductive resin formed by compounding copper, a metal powder and a resin, a hole filling resin, or the like.

Circuit board 30 has a base member 31, a wiring layer 32 and a wiring layer 33. Base member 31 has a main surface 31a and a main surface 31b. Main surface 31a and main surface 31b are end faces in a thickness direction of base member 31. Main surface 31b is opposite to main surface 31a. Base member 31 is provided with a through hole 31c. Through hole 31c passes through base member 31 in the thickness direction. Base member 31 is made of glass cloth and a resin material impregnated into glass cloth. Main surface 31a has a component arrangement region 31d.

Wiring layer 32 is arranged on main surface 31a. Wiring layer 33 is arranged on main surface 31b. Each of wiring layer 32 and wiring layer 33 has an underlying layer 34 and a plated layer 35. Underlying layer 34 has a first layer 34a and a second layer 34b. A constituent material for underlying layer 34 and a constituent material for plated layer 35 are, for example, copper, nickel, gold or the like.

First layer 34a constituting a part of wiring layer 32 is arranged on main surface 31a. First layer 34a constituting a part of wiring layer 33 is arranged on main surface 31b. Second layer 34b is arranged on first layer 34a. Second layer 34b is also arranged on an inner wall surface of through hole 31c. Wiring layer 32 and wiring layer 33 are electrically connected to each other by second layer 34b arranged on the inner wall surface of through hole 31c. Plated layer 35 is arranged on underlying layer 34. A filling member 36 is filled into through hole 31c. A constituent material for filling member 36 is, for example, a conductive resin formed by compounding copper, a metal powder and a resin, a hole filling resin, or the like.

Circuit board 10, circuit board 20 and circuit board 30 are stacked. In a state where circuit board 10, circuit board 20 and circuit board 30 are stacked, main surface 11a and main surface 21a face each other and main surface 11b and main surface 31a face each other. In a state where circuit board 10, circuit board 20 and circuit board 30 are stacked, recess 11d faces component arrangement region 21d and recess 11e faces component arrangement region 31d.

Wiring layer 12 is provided with a groove 12a. Wiring layer 13 is provided with a groove 13a. Groove 12a is formed in plated layer 15 constituting a part of wiring layer 12. Groove 13a is formed in plated layer 15 constituting a part of wiring layer 13. Wiring layer 22 has a protrusion 22a. Protrusion 22a is configured of plated layer 25 constituting a part of wiring layer 22. Wiring layer 32 has a protrusion 32a. Protrusion 32a is configured of plated layer 35 constituting a part of wiring layer 32.

Protrusion 22a surrounds component arrangement region 21d in a plan view. Protrusion 32a surrounds component arrangement region 31d in a plan view. Protrusion 22a may surround component arrangement region 21d a plurality of times in a plan view, and protrusion 32a may surround component arrangement region 21d a plurality of times in a plan view.

Groove 12a surrounds component arrangement region 21d in a plan view. Groove 13a surrounds component arrangement region 31d in a plan view. Groove 12a may surround component arrangement region 21d a plurality of times in a plan view, and groove 13a may surround component arrangement region 31d a plurality of times in a plan view.

Protrusion 22a and protrusion 32a face groove 12a and groove 13a, respectively. Protrusion 22a and protrusion 32a are fitted to groove 12a and groove 13a, respectively, whereby circuit board 10, circuit board 20 and circuit board 30 are maintained in a stacked state. Although not shown, circuit board 10, circuit board 20 and circuit board 30 may be fixed to each other by screwing or the like after protrusion 22a and protrusion 32a are fitted to groove 12a and groove 13a, respectively.

Protrusion 22a and protrusion 32a may be formed on through hole 21c provided with second layer 24b and filled with filling member 26 and on through hole 31c provided with second layer 34b and filled with filling member 36, respectively. Groove 12a that faces protrusion 22a and groove 13a that faces protrusion 32a may be formed on through hole 11c provided with second layer 14b and filled with filling member 16. As a result, protrusion 22a and protrusion 32a are fitted to groove 12a and groove 13a directly above through hole 11c, through hole 21c and through hole 31c, which results in improved heat conductivity between circuit board 10 and circuit boards 20 and 30.

That is, stack circuit board 100 has a first via hole portion and a second via hole portion. The first via hole portion is configured of through hole 11c passing through circuit board 10, second layer 14b of underlying layer 14 provided on the inner wall surface of through hole 11c, and filling member 16 that fills through hole 11c provided with second layer 14b. The second via hole portion is configured of through hole 21c passing through circuit board 20, second layer 24b of underlying layer 24 provided on the inner wall surface of through hole 21c, and filling member 26 that fills through hole 21c provided with second layer 24b.

Plated layer 15 is formed on the first via hole portion of main surface 11a including filling member 16, and plated layer 25 is formed on the second via hole portion of main surface 21a including filling member 26. Plated layer 25 on the second via hole is provided with protrusion 22a. Plated layer 15 on the first via hole is provided with groove 12a. Groove 12a and protrusion 22a are fitted, whereby circuit board 10 and circuit board 20 are stacked such that the first via hole portion of main surface 11a and the second via hole portion of main surface 21a face each other. Plated layer 25 on the second via hole may be provided with the groove and plated layer 15 on the first via hole may be provided with the protrusion, and the groove and the protrusion may be fitted, whereby circuit board 10 and circuit board 20 may be stacked such that the first via hole portion of main surface 11a and the second via hole portion of main surface 21a face each other.

Further, stack circuit board 100 has a third via hole portion. The third via hole portion is configured of through hole 31c passing through circuit board 30, second layer 34b of underlying layer 34 provided on the inner wall surface of through hole 31c, and filling member 36 that fills through hole 31c provided with second layer 34b.

Plated layer 35 is formed on the third via hole portion including filling member 36 of main surface 31a. Plated layer 35 on the third via hole is provided with protrusion 32a. Plated layer 15 on the first via hole on the main surface 11b side of circuit board 10 is provided with groove 13a. Groove 13a and protrusion 32a are fitted, whereby circuit board 10 and circuit board 30 are stacked such that the first via hole portion of main surface 11b and the third via hole portion of main surface 31a face each other. Plated layer 35 on the third via hole may be provided with the groove and plated layer 15 on the first via hole may be provided with the protrusion, and the groove and the protrusion may be fitted, whereby circuit board 10 and circuit board 30 may be stacked such that the first via hole portion of main surface 11b and the second via hole portion of main surface 31a face each other.

Electronic component 40 is connected to wiring layer 22 in a space defined by recess 11d and component arrangement region 21d. Electronic component 40 in component arrangement region 21d constitutes one circuit block. Electronic component 41 is connected to wiring layer 32 in a space defined by recess 11e and component arrangement region 31d. Electronic component 41 in component arrangement region 31d constitutes one circuit block. The connection between electronic component 40 and wiring layer 22 and the connection between electronic component 41 and wiring layer 32 are made by, for example, soldering.

### (Method for Manufacturing Stack Circuit Board 100)

A method for manufacturing stack circuit board 100 will be described below.

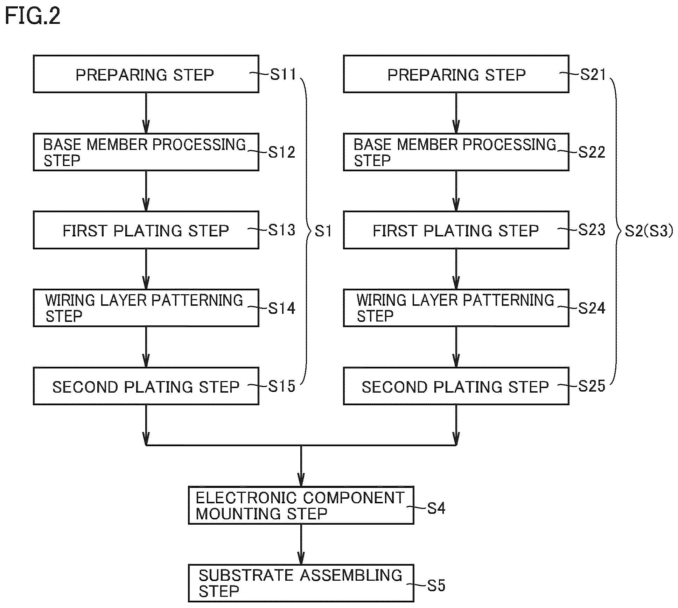

Fig. 2 is a diagram of a process for manufacturing stack circuit board 100. As shown in Fig. 2, the method for manufacturing stack circuit board 100 has a first circuit board forming step S1, a second circuit board forming step S2, a third circuit board forming step S3, an electronic component mounting step S4, and a circuit board assembling step S5.

First circuit board forming step S1 has a preparing step S11, a base member processing step S12, a first plating step S13, a wiring layer patterning step S14, and a second plating step S15.

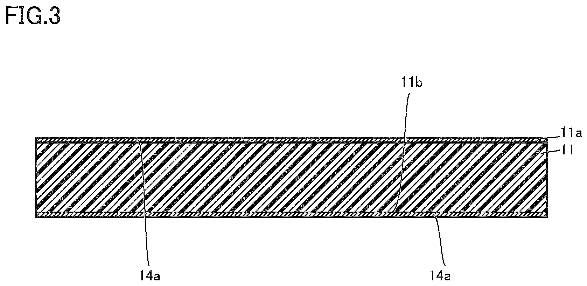

Fig. 3 is a cross-sectional view illustrating preparing step S11. As shown in Fig. 3, in preparing step S11, base member 11 is prepared. In base member 11 prepared in preparing step S11, first layer 14a is arranged on main surface 11a and on main surface 11b.

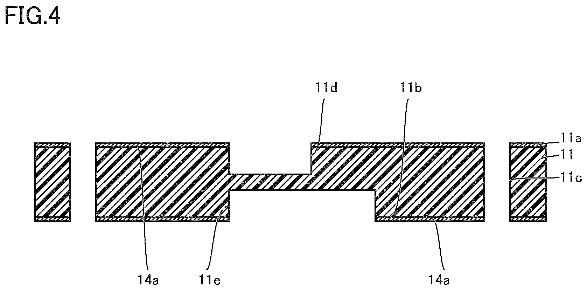

Fig. 4 is a cross-sectional view illustrating base member processing step S12. As shown in Fig. 4, in base member processing step S12, hole drilling is performed on base member 11. As a result, through hole 11c is formed in base member 11. In base member processing step S12, counterboring is also performed on base member 11. As a result, recess 11d and recess 11e are formed.

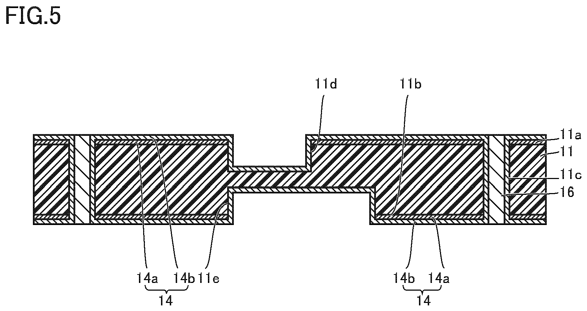

Fig. 5 is a cross-sectional view illustrating first plating step S13. As shown in Fig. 5, in first plating step S13, electroless plating, copper sulfate plating or the like is performed, whereby second layer 14b is formed on first layer 14a. At this time, second layer 14b is also formed on the inner wall surface of through hole 11c, on the side surface and the bottom surface of recess 11d, and on the side surface and the bottom surface of recess 11e. After second layer 14b is formed, filling member 16 is filled into through hole 11c.

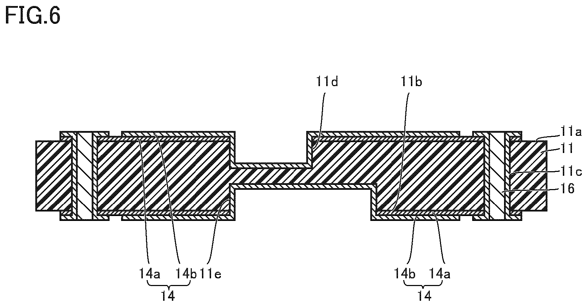

Fig. 6 is a cross-sectional view illustrating wiring layer patterning step S14. As shown in Fig. 6, in wiring layer patterning step S14, underlying layer 14 is patterned by etching using a resist pattern formed on underlying layer 14 as a mask.

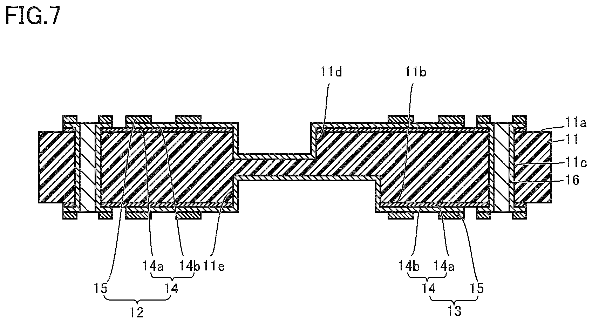

Fig. 7 is a cross-sectional view illustrating second plating step S15. As shown in Fig. 7, in second plating step S15, plated layer 15 is formed. In second plating step S15, firstly, a resist pattern is formed on underlying layer 14. Underlying layer 14 is exposed from an opening of the resist pattern. Secondly, electroplating is, for example, performed, whereby plated layer 15 is grown on underlying layer 14 exposed from the opening of the resist pattern. That is, in second plating step S15, plated layer 15 is formed by, for example, a semi-additive method. After second plating step S15 is performed, contour machining, solder resist application, surface treatment or the like is performed as a subsequent step.

Second circuit board forming step S2 has a preparing step S21, a base member processing step S22, a first plating step S23, a wiring layer patterning step S24, and a second plating step S25.

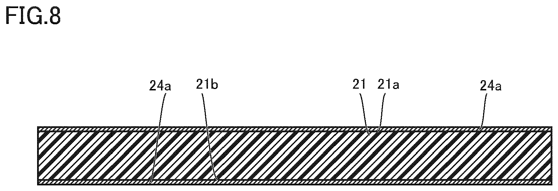

Fig. 8 is a cross-sectional view illustrating preparing step S21. As shown in Fig. 3, in preparing step S21, base member 21 is prepared. In base member 21 prepared in preparing step S21, first layer 24a is arranged on main surface 21a and on main surface 21b.

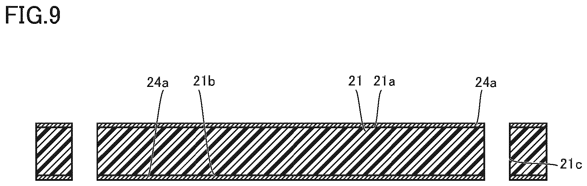

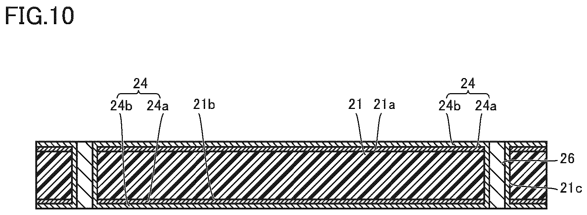

Fig. 9 is a cross-sectional view illustrating base member processing step S22. As shown in Fig. 9, in base member processing step S22, hole drilling is performed on base member 21, whereby through hole 21c is formed in base member 21. Fig. 10 is a cross-sectional view illustrating first plating step S23. As shown in Fig. 10, in first plating step S23, electroless plating, copper sulfate plating or the like is performed, whereby second layer 24b is formed on first layer 24a. At this time, second layer 24b is also formed on the inner wall surface of through hole 21c. After second layer 24b is formed, filling member 26 is filled into through hole 21c.

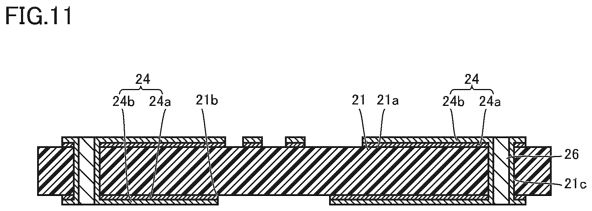

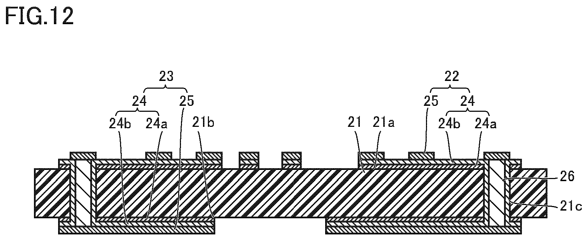

Fig. 11 is a cross-sectional view illustrating wiring layer patterning step S24. As shown in Fig. 11, in wiring layer patterning step S24, underlying layer 24 is patterned by etching using a resist pattern formed on underlying layer 24 as a mask. Fig. 12 is a cross-sectional view illustrating second plating step S25. As shown in Fig. 12, in second plating step S25, plated layer 25 is formed. In second plating step S25, firstly, a resist pattern is formed on underlying layer 24. Underlying layer 24 is exposed from an opening of the resist pattern. Secondly, electroplating is, for example, performed, whereby plated layer 25 is grown on underlying layer 24 exposed from the opening of the resist pattern. That is, in second plating step S25, plated layer 25 is formed by, for example, the semi-additive method. After second plating step S25 is performed, contour machining, solder resist application, surface treatment or the like is performed as a subsequent step.

In third circuit board forming step S3, circuit board 30 is formed. Since third circuit board forming step S3 is similar to second circuit board forming step S2, description will not be repeated.

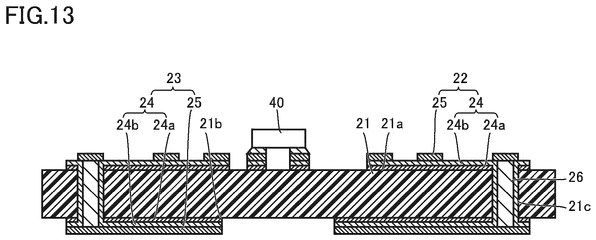

Fig. 13 is a cross-sectional view illustrating electronic component mounting step S4. As shown in Fig. 13, in electronic component mounting step S4, electronic component 40 is mounted onto wiring layer 12 in component arrangement region 21d. Electronic component 40 is mounted by, for example, soldering. Although not shown, electronic component 41 is similarly mounted onto wiring layer 32 in component arrangement region 31d.

In circuit board assembling step S5, firstly, circuit board 10, circuit board 20 and circuit board 30 are arranged such that main surface 11a faces main surface 21a and main surface 11b faces main surface 21a. More specifically, circuit board 10, circuit board 20 and circuit board 30 are arranged such that protrusion 22a faces groove 12a and protrusion 32a faces groove 13a. Secondly, circuit board 20 and circuit board 30 are pushed toward circuit board 10. As a result, protrusion 22a is fitted to groove 12a and protrusion 32a is fitted to groove 13a. Furthermore, circuit board 10, circuit board 20 and circuit board 30 may be fixed to each other by, for example, screwing. As described above, the structure of stack circuit board 100 shown in Fig. 1 is formed.

The first via hole portion configured of through hole 11c, second layer 14b provided on the inner wall surface of through hole 11c, and filling member 16, the second via hole portion configured of through hole 21c, second layer 24b provided on the inner wall surface of through hole 21c, and filling member 26, and the third via hole portion configured of through hole 31c, second layer 34b provided on the inner wall surface of through hole 31c, and filling member 36 may be provided, and plated layer 15, plated layer 25 and plated layer 35 may be provided on the respective via hole portions. In this case, groove 12a and groove 13a may be formed in plated layer 15, protrusion 22a may be formed on plated layer 25, and protrusion 32a may be formed on plated layer 35. Then, groove 12a and protrusion 22a may be fitted and groove 13a and protrusion 32a may be fitted. Alternatively, a protrusion may be formed on plated layer 15, a groove may be formed in plated layer 25, and a groove may be formed in plated layer 35, and these grooves and protrusion may be fitted, whereby circuit board 10, circuit board 20 and circuit board 30 may be stacked.

### (Effects of Stack Circuit Board 100)

The effects of stack circuit board 100 will be described below.

In stack circuit board 100, protrusion 22a (protrusion 32a) is fitted to groove 12a (groove 13a) and surrounds component arrangement region 21d (component arrangement region 31d) in a plan view. Therefore, the circuit block configured of electronic component 40 (electronic component 41) can be electromagnetically shielded.

In stack circuit board 100, the shield structure configured of protrusion 22a (protrusion 32a) and groove 12a (groove 13a) can be formed by a commonly-used circuit board manufacturing process, which makes it possible to freely determine the arrangement of the shield structure. Further, in stack circuit board 100, protrusion 22a (protrusion 32a) is formed by the semi-additive method, which makes it possible to decrease the width of protrusion 22a (protrusion 32a) to approximately 50 µm. That is, stack circuit board 100 enables a reduction in size of a region where the shield structure is formed.

When protrusion 22a (protrusion 32a) surrounds component arrangement region 21d (component arrangement region 31d) a plurality of times in a plan view, i.e., when the shield structure has a labyrinth structure, the shield structure is less likely to be affected by deformation of circuit board 10 and circuit board 20 (circuit board 30), which results in an improved shielding property.

In a conventional shield design for a circuit block, a method of attaching a case that brings a circuit block to a ground potential, or a method of adjusting a pitch for bump bonding using solder (e.g., soldering of a ball grid array (BGA)) to 1/4 or less of a wavelength of an electromagnetic wave has been adopted. However, regarding the attachment of the case, a space required for attachment of the case must be secured and an additional step is required to attach the case. Regarding the pitch adjustment for bump bonding, there is always a gap between pitches, and thus, the circuit block may not operate normally due to external interference that is not taken into consideration at the design stage or oscillation from within the circuit block. Stack circuit board 100 has no concept of a pitch for bump bonding and a gap between pitches, which eliminates the need to design stack circuit board 100 with a pitch for bump bonding in mind.

Further, fitting on the via hole portions results in improved heat conductivity between the circuit boards, i.e., between circuit board 10 and circuit board 20 and between circuit board 10 and circuit board 30.

### (First Modification)

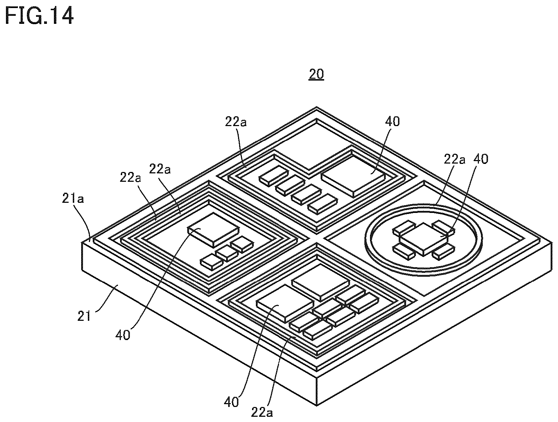

Fig. 14 is a perspective view of circuit board 20 in stack circuit board 100 according to a first modification. As shown in Fig. 14, the shape of protrusion 22a in a plan view is not particularly limited. The shape of protrusion 22a in a plan view may be a rectangular shape, or may be a circular shape, or may be a polygonal shape conforming to the arrangement of electronic component 40.

### (Second Modification)

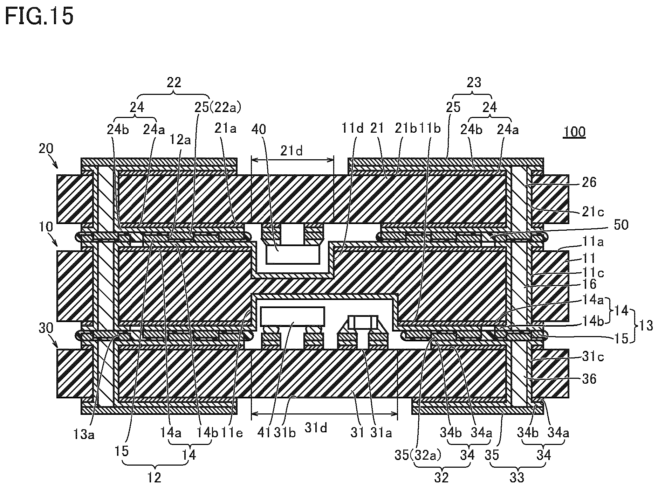

Fig. 15 is a cross-sectional view of stack circuit board 100 according to a second modification. As shown in Fig. 15, stack circuit board 100 may further have a joining member 50. Joining member 50 is, for example, an anisotropic conducting film (ACF), solder or a conductive paste. Joining member 50 is a material that enables joining at a temperature lower than the soldering temperature of electronic component 40 and electronic component 41. Protrusion 22a and groove 12a may be fitted with joining member 50 interposed therebetween, and protrusion 32a and groove 13a may be fitted with joining member 50 interposed therebetween. This enables correction of warping or twisting of each circuit board (circuit board 10, circuit board 20, circuit board 30).

### (Third Modification)

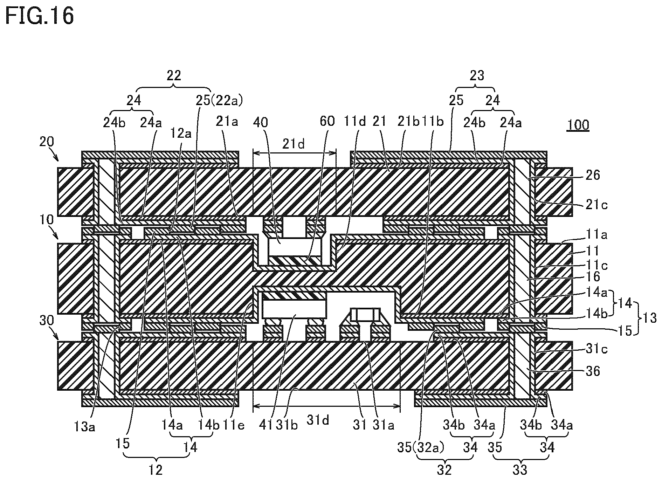

Fig. 16 is a cross-sectional view of stack circuit board 100 according to a third modification. As shown in Fig. 16, stack circuit board 100 may further have a filler 60. Filler 60 is filled between electronic component 40 and wiring layer 12 in recess 11d, and is also filled between electronic component 41 and wiring layer 13 in recess 11e. Filler 60 is, for example, a heat-conducting material such as silicone. This makes it easier to release the heat of electronic component 40 and the heat of electronic component 41 through filler 60. Filler 60 may be a radio wave absorbing material.

### (Fourth Modification)

Although the example in which wiring layer 22 and wiring layer 32 have the protrusions (protrusion 22a, protrusion 32a) and the grooves (groove 12a, groove 13a) are formed in wiring layer 12 and wiring layer 13 has been described above, wiring layer 12 and wiring layer 13 may have protrusions and grooves may be formed in wiring layer 22 and wiring layer 32.

### Second Embodiment.

A stack circuit board according to a second embodiment will be described. The stack circuit board according to the first embodiment will be referred to as a stack circuit board 200. Here, differences from stack circuit board 100 will be mainly described and redundant description will not be repeated.

### (Configuration of Stack Circuit Board 200)

A configuration of stack circuit board 200 will be described below.

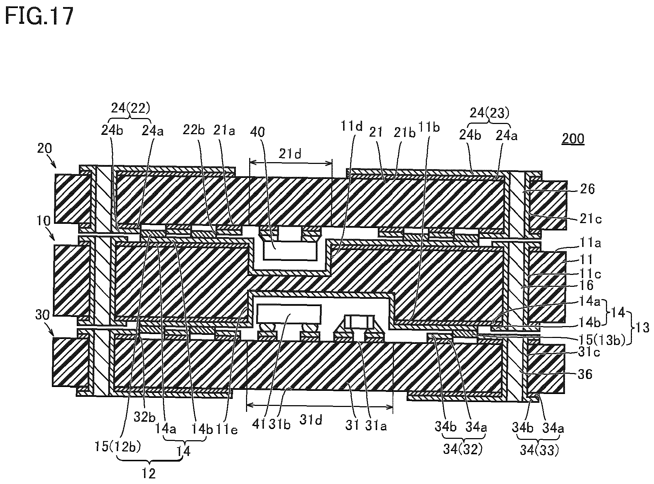

Fig. 17 is a cross-sectional view of stack circuit board 200. As shown in Fig. 17, stack circuit board 100 has circuit board 10, circuit board 20, circuit board 30, electronic component 40, and electronic component 41. In this regard, the configuration of stack circuit board 200 is the same as the configuration of stack circuit board 100.

In stack circuit board 200, wiring layer 22 and wiring layer 23 do not have plated layer 25, and wiring layer 32 and wiring layer 33 do not have plated layer 35. In stack circuit board 200, wiring layer 12 has a protrusion 12b and wiring layer 13 has a protrusion 13b. Protrusion 12b surrounds component arrangement region 21d in a plan view. Protrusion 13b surrounds component arrangement region 31d in a plan view. In stack circuit board 200, wiring layer 22 is provided with a groove 22b and wiring layer 32 is provided with a groove 32b. More specifically, groove 22b is formed in underlying layer 24 constituting a part of wiring layer 22 and groove 32b is formed in underlying layer 34 constituting a part of wiring layer 32. Protrusion 12b and protrusion 13b are fitted to groove 22b and groove 32b, respectively. In these regards, the configuration of stack circuit board 200 is different from the configuration of stack circuit board 100.

### (Effects of Stack Circuit Board 200)

The effects of stack circuit board 200 will be described below.

In stack circuit board 200, protrusion 12b (protrusion 13b) is fitted to groove 22b (groove 32b) and surrounds component arrangement region 21d (component arrangement region 31d) in a plan view. Therefore, similarly to stack circuit board 100, the circuit block configured of electronic component 40 (electronic component 41) can be electromagnetically shielded.

In stack circuit board 200, plated layer 25 and plated layer 35 are not formed and the plating steps for forming plated layer 25 and plated layer 35 when forming circuit board 20 and circuit board 30 can be omitted, which can result in a simpler manufacturing process than that for stack circuit board 100. In stack circuit board 200, plated layer 25 and plated layer 35 are not formed, with the result that wiring layer 22 and wiring layer 32 can be reduced in thickness, and thus, the patterns of wiring layer 22 and wiring layer 23 can be made finer.

In the first and second embodiments, the example in which each of base member 11, base member 21 and base member 31 is made of glass cloth and a resin material impregnated into glass cloth has been described. In addition to the case in which each of base member 11, base member 21 and base member 22 is made of glass cloth and a resin material impregnated into glass cloth, each of base member 11, base member 21 and base member 22 may be made of a material that does not contain glass cloth, such as a composite base member epoxy circuit board formed by impregnating a paper base member with an epoxy resin, or a polyimide circuit board formed by impregnating a paper base member with a polyimide resin. Each of base member 11, base member 21 and base member 31 may be made of a material formed by compounding a resin material with a filler. Each of base member 11, base member 21 and base member 31 may be made of a material formed by impregnating glass cloth with an epoxy resin or a PTFE resin (tetrafluoroethylene resin).

### (Additional Aspects)

Various configurations of the present disclosure will be summarized as additional aspects.

### <Additional Aspect 1>

A stack circuit board comprising:
a first circuit board;
a second circuit board; and
an electronic component, wherein
the first circuit board has a first base member and a first wiring layer made of a conductive material and formed on a first main surface of the first base member,
the second circuit board has a second base member and a second wiring layer made of a conductive material and formed on a second main surface of the second base member,
the first main surface is provided with a recess,
the second main surface has a component arrangement region facing the recess and having the electronic component arranged therein,
the electronic component is connected to the second wiring layer in a space defined by the recess and the component arrangement region,
one of the first wiring layer and the second wiring layer has a protrusion,
the other of the first wiring layer and the second wiring layer is provided with a groove,
the protrusion and the groove surround the component arrangement region in a plan view, and
the groove and the protrusion are fitted, whereby the first base member and the second base member are stacked such that the first main surface and the second main surface face each other.

### <Additional Aspect 2>

The stack circuit board according to Additional Aspect 1, further comprising a joining member, wherein
the protrusion and the groove are fitted with the joining member interposed therebetween.

### <Additional Aspect 3>

The stack circuit board according to Additional Aspect 1 or 2, further comprising
a filler interposed between the electronic component and the first wiring layer in the recess.

### <Additional Aspect 4>

The stack circuit board according to Additional Aspect 3, wherein
the filler is a heat-conducting material or a radio wave absorbing material.

### <Additional Aspect 5>

The stack circuit board according to any one of Additional Aspects 1 to 4, wherein
the first wiring layer has a first underlying layer and a first plated layer arranged on the first underlying layer,
the second wiring layer has a second underlying layer and a second plated layer arranged on the second underlying layer,
one of the first plated layer and the second plated layer constitutes the protrusion, and
the other of the first plated layer and the second plated layer is provided with the groove.

### <Additional Aspect 6>

The stack circuit board according to any one of Additional Aspects 1 to 4, wherein
the first wiring layer has a first underlying layer and a first plated layer arranged on the first underlying layer,
the second wiring layer has a second underlying layer,
the first plated layer constitutes the protrusion, and
the second underlying layer is provided with the groove.

### <Additional Aspect 7>

The stack circuit board according to Additional Aspect 5, comprising:
a first via hole portion configured of a first through hole passing through the first circuit board, the first underlying layer provided on an inner wall surface of the first through hole, and a first filling member that fills the first through hole provided with the first underlying layer; and
a second via hole portion configured of a second through hole passing through the second circuit board, the second underlying layer provided on an inner wall surface of the second through hole, and a second filling member that fills the second through hole provided with the second underlying layer, wherein
the first plated layer is formed on the first via hole portion of the first main surface including the first filling member, and the second plated layer is formed on the second via hole portion of the second main surface including the second filling member,
one of the first plated layer and the second plated layer constitutes the protrusion,
the other of the first plated layer and the second plated layer is provided with the groove, and
the groove and the protrusion are fitted, whereby the first base member and the second base member are stacked such that the first via hole portion of the first main surface and the second via hole portion of the second main surface face each other.

### <Additional Aspect 8>

A method for manufacturing a stack circuit board, comprising:
preparing a first circuit board, a second circuit board and an electronic component;
forming a recess in a first main surface of a first base member constituting the first circuit board;
forming, on the first main surface, a first wiring layer made of a conductive material;
forming, on a second main surface of a second base member constituting the second circuit board, a second wiring layer made of a conductive material;
forming, in one of the first wiring layer and the second wiring layer, a protrusion that surrounds a component arrangement region when the component arrangement region is viewed in a plan view, and forming, in the other of the first wiring layer and the second wiring layer, a groove that surrounds the component arrangement region when the component arrangement region is viewed in a plan view, the component arrangement region facing the recess and having the electronic component arranged therein in the second main surface;
connecting the electronic component to the second wiring layer in a space defined by the recess and the component arrangement region; and
fitting the groove and the protrusion, thereby stacking the first base member and the second base member such that the first main surface and the second main surface face each other.

### <Additional Aspect 9>

The method for manufacturing a stack circuit board according to Additional Aspect 8, wherein
the first wiring layer is a stacked film of a first underlying layer and a first plated layer arranged on the first underlying layer,
the second wiring layer is a stacked film of a second underlying layer and a second plated layer arranged on the second underlying layer,
the method further comprising:
   forming a first via hole portion by forming a first through hole passing through the first circuit board, forming the first underlying layer on an inner wall surface of the first through hole, and filling the first through hole provided with the first underlying layer with a first filling member;
   forming a second via hole portion by forming a second through hole passing through the second circuit board, forming the second underlying layer on an inner wall surface of the second through hole, and filling the second through hole provided with the second underlying layer with a second filling member; and
   forming the first plated layer on the first via hole portion of the first main surface including the first filling member, and forming the second plated layer on the second via hole portion of the second main surface including the second filling member, wherein
   one of the first plated layer and the second plated layer constitutes the protrusion, and
   the method further comprising:
      forming the groove in the other of the first plated layer and the second plated layer; and
      fitting the groove and the protrusion, thereby stacking the first base member and the second base member such that the first via hole portion of the first main surface and the second via hole portion of the second main surface face each other.

It should be understood that the embodiments disclosed herein are illustrative and non-restrictive in every respect. The scope of the present application is defined by the terms of the claims, rather than the description above, and is intended to include any modifications within the scope and meaning equivalent to the terms of the claims.

### REFERENCE SIGNS LIST

100 stack circuit board; 10 circuit board; 11 base member; 11a, 11b main surface; 11c through hole; 11d, 11e recess; 12 wiring layer; 12a groove; 12b protrusion; 13 wiring layer; 13a groove; 13b protrusion; 14 underlying layer; 14a first layer; 14b second layer; 15 plated layer; 16 filling member; 20 circuit board; 21 base member; 21a, 21b main surface; 21c through hole; 21d component arrangement region; 22 wiring layer; 22a protrusion; 22b groove; 23 wiring layer; 24 underlying layer; 24a first layer; 24b second layer; 25 plated layer; 26 filling member; 30 circuit board; 31 base member; 31a, 31b main surface; 31c through hole; 31d component arrangement region; 32 wiring layer; 32a protrusion; 32b groove; 33 wiring layer; 34 underlying layer; 34a first layer; 34b second layer; 35 plated layer; 36 filling member; 40 electronic component; 41 electronic component; 50 joining member; 60 filler; 200 stack circuit board; S1 first circuit board forming step; S2 second circuit board forming step; S3 third circuit board forming step; S4 electronic component mounting step; S5 assembling step; S11 preparing step; S12 base member processing step; S13 first plating step; S14 wiring layer patterning step; S15 second plating step; S21 preparing step; S22 base member processing step; S23 first plating step; S24 wiring layer patterning step; S25 second plating step.

## Claims

1. A stack circuit board comprising:
a first circuit board;
a second circuit board; and
an electronic component, wherein
the first circuit board has a first base member and a first wiring layer made of a conductive material and formed on a first main surface of the first base member,
the second circuit board has a second base member and a second wiring layer made of a conductive material and formed on a second main surface of the second base member,
the first main surface is provided with a recess,
the second main surface has a component arrangement region facing the recess and having the electronic component arranged therein,
the electronic component is connected to the second wiring layer in a space defined by the recess and the component arrangement region,
one of the first wiring layer and the second wiring layer has a protrusion,
the other of the first wiring layer and the second wiring layer is provided with a groove,
the protrusion and the groove surround the component arrangement region in a plan view, and
the groove and the protrusion are fitted, whereby the first base member and the second base member are stacked such that the first main surface and the second main surface face each other.

2. The stack circuit board according to claim 1, further comprising a joining member, wherein
the protrusion and the groove are fitted with the joining member interposed therebetween.

3. The stack circuit board according to claim 1 or 2, further comprising
a filler interposed between the electronic component and the first wiring layer in the recess.

4. The stack circuit board according to claim 3, wherein
the filler is a heat-conducting material or a radio wave absorbing material.

5. The stack circuit board according to any one of claims 1 to 4,
wherein
the first wiring layer has a first underlying layer and a first plated layer arranged on the first underlying layer,
the second wiring layer has a second underlying layer and a second plated layer arranged on the second underlying layer,
one of the first plated layer and the second plated layer constitutes the protrusion, and
the other of the first plated layer and the second plated layer is provided with the groove.

6. The stack circuit board according to any one of claims 1 to 4,
wherein
the first wiring layer has a first underlying layer and a first plated layer arranged on the first underlying layer,
the second wiring layer has a second underlying layer,
the first plated layer constitutes the protrusion, and
the second underlying layer is provided with the groove.

7. The stack circuit board according to claim 5, comprising:
a first via hole portion configured of a first through hole passing through the first circuit board, the first underlying layer provided on an inner wall surface of the first through hole, and a first filling member that fills the first through hole provided with the first underlying layer; and
a second via hole portion configured of a second through hole passing through the second circuit board, the second underlying layer provided on an inner wall surface of the second through hole, and a second filling member that fills the second through hole provided with the second underlying layer, wherein
the first plated layer is formed on the first via hole portion of the first main surface including the first filling member, and the second plated layer is formed on the second via hole portion of the second main surface including the second filling member,
one of the first plated layer and the second plated layer constitutes the protrusion,
the other of the first plated layer and the second plated layer is provided with the groove, and
the groove and the protrusion are fitted, whereby the first base member and the second base member are stacked such that the first via hole portion of the first main surface and the second via hole portion of the second main surface face each other.

8. A method for manufacturing a stack circuit board, comprising:
preparing a first circuit board, a second circuit board and an electronic component;
forming a recess in a first main surface of a first base member constituting the first circuit board;
forming, on the first main surface, a first wiring layer made of a conductive material;
forming, on a second main surface of a second base member constituting the second circuit board, a second wiring layer made of a conductive material;
forming, in one of the first wiring layer and the second wiring layer, a protrusion that surrounds a component arrangement region when the component arrangement region is viewed in a plan view, and forming, in the other of the first wiring layer and the second wiring layer, a groove that surrounds the component arrangement region when the component arrangement region is viewed in a plan view, the component arrangement region facing the recess and having the electronic component arranged therein in the second main surface;
connecting the electronic component to the second wiring layer in a space defined by the recess and the component arrangement region; and
fitting the groove and the protrusion, thereby stacking the first base member and the second base member such that the first main surface and the second main surface face each other.

9. The method for manufacturing a stack circuit board according to claim 8, wherein
the first wiring layer is a stacked film of a first underlying layer and a first plated layer arranged on the first underlying layer,
the second wiring layer is a stacked film of a second underlying layer and a second plated layer arranged on the second underlying layer,
the method further comprising:
forming a first via hole portion by forming a first through hole passing through the first circuit board, forming the first underlying layer on an inner wall surface of the first through hole, and filling the first through hole provided with the first underlying layer with a first filling member;
forming a second via hole portion by forming a second through hole passing through the second circuit board, forming the second underlying layer on an inner wall surface of the second through hole, and filling the second through hole provided with the second underlying layer with a second filling member; and
forming the first plated layer on the first via hole portion of the first main surface including the first filling member, and forming the second plated layer on the second via hole portion of the second main surface including the second filling member, wherein
one of the first plated layer and the second plated layer constitutes the protrusion, and
the method further comprising:
forming the groove in the other of the first plated layer and the second plated layer; and
fitting the groove and the protrusion, thereby stacking the first base member and the second base member such that the first via hole portion of the first main surface and the second via hole portion of the second main surface face each other.
